Europäisches Patentamt

European Patent Office

Office européen des brevets

(19)

(11) **EP 0 655 152 B1**

(12) **EUROPÄISCHE PATENTSCHRIFT**

(45) Veröffentlichungstag und Bekanntmachung des Hinweises auf die Patenterteilung:
**02.05.1997 Patentblatt 1997/18**

(51) Int Cl.[6]: **G06F 17/50**

(21) Anmeldenummer: **94908125.1**

(22) Anmeldetag: **06.08.1993**

(86) Internationale Anmeldenummer:
**PCT/EP93/02105**

(87) Internationale Veröffentlichungsnummer:
**WO 94/04987 (03.03.1994 Gazette 1994/06)**

(54) **VERFAHREN ZUR SIMULATION WENIGSTENS EINES BAUELEMENTES, DESSEN KENNZEICHNENDE MERKMALE DURCH EINE MENGE VON WERTEPAAREN BESCHRIEBEN WERDEN, MITTELS EINES SIMULATORS AUF EINEM RECHNER**

METHOD OF SIMULATING, USING A COMPUTER-BASED SIMULATOR, AT LEAST ONE COMPONENT WHOSE CHARACTERISTIC FEATURES ARE DESCRIBED BY A SET OF PAIRED VALUES

PROCEDE DE SIMULATION D'AU MOINS UN COMPOSANT DONT LES CARACTERISTIQUES SONT DECRITES PAR DES VALEURS COUPLEES, AU MOYEN D'UN SIMULATEUR ASSISTE PAR ORDINATEUR

(84) Benannte Vertragsstaaten:
**DE FR GB**

(30) Priorität: **13.08.1992 EP 92113834**

(43) Veröffentlichungstag der Anmeldung:
**31.05.1995 Patentblatt 1995/22**

(73) Patentinhaber: **SIEMENS AKTIENGESELLSCHAFT**
**80333 München (DE)**

(72) Erfinder:
• **LANGE, Eberhard, Dr.**
**D-90587 Obermichelbach (DE)**
• **HAIBLE, Jürgen**
**D-91058 Erlangen-Tennenlohe (DE)**

(56) Entgegenhaltungen:
**US-A- 5 047 971**

• **ANNALES DES TELECOMMUNICATIONS MAI-JUNI 1992 Bd. 47, Nr. 5-6 Seiten 180 - 192 PEDEN ET AL 'modelisation non lineaire de transistors mesfet'**
• **12TH EUROPEAN SOLID STATE CIRCUITS CONFERENCE 1986 Seiten 211 - 213 RAUH 'a table model for circuit simulation'**
• **IEEE COMPUTER GRAPHICS AND APPLICATIONS. Bd. 10, Nr. 1, Januar 1990, LOS ALAMITOS CA US Seiten 10 - 17 FLETCHER 'automatic tension adjustment for interpolatory splines'**
• **ANNALES DES TELECOMMUNICATIONS Mai-Juni 1992 Bd. 47, Nr. 5-6, SS 180-192; PEDEN et al.: 'Modelisation non linéaire de transistors mesfet'**
• **12TH EUROPEAN SOLID STATE CIRCUITS CONFERENCE 1986, SS 211-213; RAUH: 'A table model for circuit simulation'**
• **IEEE COMPUTER GRAPHICS AND APPLICATIONS, Bd. 10, Nr. 1, Januar 1990, Los Alamitos, CA, US, SS 10-17; FLETCHER: 'Automatic tension adjustment for interpolatory splines'**

## Beschreibung

Die Erfindung betrifft ein Verfahren, mit dem Bauelemente, wie z.B. elektronische Analogbauelemente oder mechanische Bauelemente, auf einem rechnergestützten Simulator schneller und exakter als bisher üblich simuliert werden können.

Die Simulation elektronischer Baugruppen hat sich in den den letzten Jahren zu einem wichtigen Thema entwickelt. Es wird immer wieder betont, daß die Simulation vor allem die Qualität der entwickelten Schaltungen verbessern kann und zu einer Steigerung der Produktivität führt [1] - [3]. Der Verbreitungsgrad der Simulation ist dennoch vor allem bei der Flachbaugruppenentwicklung relativ gering. Die Gründe dafür sind sowohl organisatorischer als auch technischer Art.

Eines der technischen Hemmnisse bei der Simulation - sowohl auf der digitalen als auch der analogen Seite - ist das Fehlen von geeigneten Modellen [3]. Während es bei der digitalen Simulation um die logische und zeitliche Beschreibung eines Bausteins mit einer entsprechenden Programmiersprache geht, handelt es sich bei Analogsimulation um die Umsetzung vorgegebener Meßkurven in mathematische Gleichungen, die mit Hilfe einer Modellierungssprache formuliert werden müssen. Obwohl derzeit auf dem Gebiet der analogen Modellierungssprachen kein Standard zu erkennen ist, bieten die meisten Simulatoren doch zumindest die Möglichkeit der Eingabe von mathematischen Funktionsgleichungen. Daher ist das Problem der Modellierung im wesentlichen auf die Gewinnung solcher Gleichungen reduziert.

Aus [5] ist ein Verfahren zur Simulation von elektronischen Schaltungen bekannt, wobei die Bauteileigenschaften durch einzelne Meßpunkte gegeben sind. Zur Interpolation zwischen den Meßpunkten werden B-Spline Funktionen der Ordnung $(N+1)$ herangezogen, um die Übergänge an den Stützstellen bis zur N-ten Ableitung stetig zu gestalten. [6] beschreibt kubische nichtparametrische Splines, die zur Interpolation von Wertepaaren $(x_i, y_i)$ verwendet werden, wobei zusätzlich zur Vermeidung von unnatürlichen Schwingungen der interpolierten Kurve ein Formungsparameter eingeführt wird. An den Stützstellen ist der Übergang bis zur zweiten Ableitung stetig.

Die Anforderungen an mathematische Gleichungen, die das physikalische Verhalten eines Bauteils beschreiben sollen, spalten sich in zwei Gruppen von Forderungen auf: Auf der einen Seite soll das physikalische Verhalten möglichst exakt beschrieben werden. Bei elektronischen Bauteilen liefert die Theorie oft für verschiedene Arbeitsbereiche auch unterschiedliche Beschreibungsfunktionen. Meistens ist es nicht möglich, ein Bauteil über den gesamten Arbeitsbereich auch mit nur einer Funktion zu beschreiben. Auf der anderen Seite sollen die Modelle möglichst effizient sein, der Simulator muß sie also schnell abarbeiten können. Je komplizierter die funktionalen Beschreibungen sind, desto langsamer läuft die Simulation ab. Gerade bei den für die Simulation besonders interessanten komplexen Schaltungen, spielt der Faktor "Simulationszeit" eine entscheidende Rolle.

Die der Erfindung zugrundeliegende Aufgabe besteht darin, ein verbessertes Verfahren zur Simulation wenigstens eines Bauelementes anzugeben, das schneller und exakter arbeitet als bisher übliche Verfahren.

Diese Aufgabe wird gemäß den Merkmalen des Patentanspruches 1 gelöst.

Alle übrigen Weiterbildungen der Erfindung ergeben sich aus den Unteransprüchen.

Es werden zunächst die für die Modellierung relevanten mathematischen Grundlagen beschrieben. Anschließend wird das von uns erfundene Verfahren vorgestellt. Im Anschluß wird anhand eines praktischen Beispiels (Strombegrenzerdiode F452) die Leistungsfähigkeit demonstriert.

## Mathematische Grundlagen

### Voraussetzungen

Wir gehen von der Tatsache aus, daß das physikalische Verhalten eines Bauteils in Form einer Funktion f graphisch vorgegeben ist. Aus dem Funktionsgraphen lassen sich Datenpunkte $(x_i, y_i)$, $i = 1,...,n$ mit $n \in N$ und $y_i = f(x_i)$ entnehmen. Das Ziel ist es, diese Datenpunkte und den dazwischenliegenden Kurvenverlauf der Funktion f durch mathematische Funktionen möglichst gut zu beschreiben.

Sei $n \in N$, $M := \{1,2,...,n\}$. Seien $a,b \in R$ mit $a<b$. Sei $(x_i)_{i \in M}$ eine reelle, aufsteigende Familie mit $x_1=a$, $x_n=b$, sei $(y_i)_{i \in M}$ eine reelle Familie. Dann versteht man unter der Partitionierung des Intervalls $I:=[a,b]$ die Menge der Teilintervalle $I_i$, $i \in M\backslash\{n\}$, wo $I_i:=[x_i;x_{i+1}]$. Die Familie $(x_i, y_i)_{i \in M}$ wird auch als Menge der Datenpunkte D bezeichnet.

Sei $m \in N$. Dann bezeichnet $C^m[I]$ die Menge der auf I m-mal stetig-differenzierbaren Funktionen.

### Splines

Sei $I:= [a,b]$ ein Intervall mit einer zugehörigen Partitionierung. Unter einem Spline vom Grad m $(m \in N)$ versteht man eine auf I definierte Funktion $s: I \to R$, $x \mapsto s(x)$ mit den folgenden Zusatzeigenschaften:

(i) $s \in C^{m-1}[I]$

(ii) Auf jedem Teilintervall $I_i$ ist s ein Polynom höchstens vom Grad m.

Die Eigenschaft (i) bedeutet, daß ein Spline vom Grad m (m-1)-mal stetig differenzierbar ist.

Ein Spline heißt kubischer Spline, wenn sein Grad m=3 ist. Ein kubischer Spline ist damit 2-mal stetig differenzierbar und ist auf jedem Teilintervall $I_i$ ein Polynom höchstens dritten Grades.

Ein Spline heißt interpolierender Spline zur Partitionierung $I_i$ und zur Menge der Datenpunkte D, wenn gilt:

$$s(x_i) = y_i \text{ für } i = 1,...,n \qquad (2.1)$$

Kubische interpolierende Splines werden im folgenden einfach Splines genannt.

## Existenz und Eindeutigkeit der Splines

Sei $I := [a,b]$ wieder ein Intervall mit einer zugehörigen Partitionierung. Sei $f \in C^2[I]$, s: $1 \to R$ Spline. Erfüllt s eine der nachfolgenden Bedingungen, so ist s eindeutig bestimmt:

$$(i) \qquad s''(a) = s''(b) = 0$$

$$(ii) \qquad s'(a) = f'(a) \text{ und } s'(b) = f'(b) \qquad (2.2)$$

Im Fall (i) wird s auch als natürlicher Spline bezeichnet. Im Fall (ii) wird vorausgesetzt, daß die Ableitungen der Funktion f in den Randpunkten a,b bekannt sind.

## Praktische Konsequenzen der Interpolation mit Splines

Da $s \in C^2[I]$, folgt insbesondere, daß in den Datenpunkten gilt:

$$s(x_i^+) = s(x_i^-) = y_i \text{ für } i = 1,...,n \qquad (2.3)$$

$$s'(x_i^+) = s'(x_i^-) \text{ für } i = 2,...,n-1 \qquad (2.4)$$

sowie

$$s''(x_i^+) = s''(x_i^-) \text{ für } i = 2,...,n-1 \qquad (2.5)$$

Dabei bezeichnet $s(x_i^+)$ den Funktionswert des Splines, der durch das repräsentierende Polynom dritter Ordnung im Teilintervall $[x_i, x_{+1}]$ an der Stelle $x_i$ gegeben ist. Analog bezeichnet $s(x_i^-)$ den Funktionswert des Polynoms im Teilintervall $[x_{i-1}, x_i]$ an der Stelle $x_i$.

Die Datenpunkte $(x_i, y_i)_{i \in M}$ werden also durch eine 2-mal stetig differenzierbare Funktion interpoliert. Die Datenpunkte liegen explizit auf dem Funktionsgraphen. Insbesondere erhält man eine glatte Kurve, die keine "Sprünge" (Unstetigkeitsstellen) oder "Knicke" (nicht-differenzierbare Stellen) besitzt.

Die zweite Ableitung $s''(x)$ des Splines ist auf jedem Teilintervall ein lineares Polynom.

## Minimaleigenschaft der Splines

Die Menge der auf dem Intervall I stetig-differenzierbaren Funktionen, deren zweite Ableitung fast überall existiert und quadratisch Lebesgue-integrabel ist, wird mit $H^2[I]$ bezeichnet. Damit läßt sich für Funktionen $f \in H^2[I]$ die Halbnorm

$$\|f\| := \sqrt{\int_a^b |f''(x)|^2 \, dx}$$

definieren. $|f''(x)|$ ist ein Maß für das Krümmungsverhalten von f an der Stelle x. Die Krümmung im quadratischen Mittel ist also gerade durch $\|f\|$ gegeben.

Die Minimaleigenschaft der Splines besagt nun, daß der natürliche Spline s von allen Funktionen $f \in C^2[I]$, für die $f(x_i) = y_i$ für i=1,...,n gilt, den kleinstmöglichen Wert für die Krümmung im quadratischen Mittel liefert In diesem Sinne ist der Spline also die glatteste interpolierende Funktion für die gegebenen Datenpunkte.

### Konvergenzelgenschaft der Splines

Splines konvergieren gegen die Funktion, die sie interpolieren, wenn man die Partitionierungen $I_i$ immer feiner wählt Dies gilt im Gegensatz zur Interpolation mit gewöhnlichen Polynomen. Bei der Interpolation mit Splines ist man also nicht aus prinzipiellen Gründen in der erreichbaren Genauigkeit der Interpolation beschränkt,

### Spline-Algorithmen als Matrixgleichungen

Die systematische Auswertung der zuvor genannten Bedingungen führen auf Matrixgleichungen, die mit Hilfe von Algorithmen für lineare Gleichungssysteme gelöst werden können (genaueres siehe [4]).

### Bogenlänge von Splines

Die Bogenlänge einer beliebigen Funktion. also insbesondere des Splines s ist durch

$$b(s) = \int_a^b \sqrt{1+(s'(x))^2} \, dx \tag{2.6}$$

gegeben. Dieses Integral läßt sich zwar prinzipiell explizit berechnen, dies ist jedoch recht mühsam. Bei der konkreten Berechnung greift man daher auf numensche Verfahren (siehe zum Beispiel [4]) zurück.

### Beschreibung der Algorithmen

### Voraussetzungen

Die Datenpunkte werden in der Praxis zumeist einer auf einem Datenblatt vorgegebenen Funktionskurve entnommen. Solche physikalischen Kurven enthalten oft zumindest optisch "Knicke", die in erster Näherung als nicht-differenzierbare Punkte angesehen werden können. Dies ist zum Beispiel bei der Kennlinie einer Diode (Durchbruchsspannung) der Fall. Deshalb ist in den hier beschriebenen Algorithmen die Möglichkeit von nicht-differenzierbaren Punkten explizit vorgesehen. Weitere markante Punkte, die man aus einem Datenblatt entnehmen kann, sind relative Maxima und Minima Die Möglichkeit, bestimmte Punkte explizit als Extrema zu definieren, ist in unseren Algorithmen ebenfalls vorgesehen.

### Geschlossener Spline-Algorithmus

Die Interpolation mit Splines läßt sich auch ohne die Verwendung von Matrizen als Algorithmus formulieren. In diesem Unterkapitel wird das Kernstück unserer Algorithmen als matrixunabhängige natürliche Spline-Interpolation formuliert. Der Algorithmus ist autonom, insbesondere werden keine Matrizen eingesetzt.

Der Spline im Teilintervall $I_i$ läßt sich schreiben als

$$s(x) = a_{i,3} \cdot (x-x_i)^3 + a_{i,2} \cdot (x-x_i)^2 + a_{i,1} \cdot (x-x_i) + a_{i,0} \qquad (3.1)$$

wo $i \in M i \backslash \{n\}$ mit n>1.

Ziel des Algorithmus ist also die Bestimmung der Koeffizienten $a_{i,0}$, $a_{i,1}$, $a_{i,2}$ und $a_{i,3}$ in jedem Teilintervall. Für n < 2 (Teilintervall mit weniger als zwei Punkten) ist der Algorithmus nicht anwendbar und wird mit einem Fehler abgebrochen. Ebenso führen Datenpunkte, deren Ordinaten nicht in aufsteigender Reihenfolge angeordnet sind ($x_j \geq x_{j+1}$), zu einem Fehler und Abbruch.

Durch Differenzieren von (3.1) folgt:

$$s'(x) = 3 \cdot a_{i,3} \cdot (x-x_i)^2 + 2 \cdot a_{i,2} \cdot (x-x_i) + a_{i,1}$$

$$s''(x) = 6 \cdot a_{i,3} \cdot (x-x_i) + 2 \cdot a_{i,2} \qquad (3.2)$$

Aus (3.1) und (3.2) folgt:

$$s(x_i) = a_{i,0}$$

$$s'(x_i) = a_{i,1}$$

$$s''(x_i) = 2 \cdot a_{i,2}$$

$$s''(x_{i+1}) = 6 \cdot a_{i,3} \cdot (x_{i+1}-x_i) + 2 \cdot a_{i,2}$$

Auflösen dieser Gleichungen nach den Koeffizienten ergibt $\forall\ i \in M \backslash \{n\}$:

$$a_{i,0} = y_i$$

$$a_{i,1} = s'(x_i)$$

$$a_{i,2} = \frac{1}{2} \cdot s''(x_i)$$

$$a_{i,3} = \frac{s''(x_{i+1}) - s''(x_i)}{6 \cdot (x_{i+1}-x_i)} \qquad (3.3)$$

Die ersten und zweiten Ableitungen $s'(x_i)$ und $s''(x_i)$ können mit einem iterativen Verfahren berechnet werden. Dazu werden zunächst Differenzen $\Delta_x^i$, $\Delta_y^i$ und Differenzenquotienten $\Delta^i$ definiert:

$$\Delta_x^i := x_{i+1} - x_i$$

$$\Delta_y^i := y_{i+1} - y_i$$

$$\Delta^i := \frac{\Delta_y^i}{\Delta_x^i} \qquad (3.4)$$

Mit Hilfe der Gleichungen (3.1) und (3.2) erhält man:

$$s(x_{i+1}) = a_{i,3} \cdot (\Delta_x^i)^3 + a_{i,2} \cdot (\Delta_x^i)^2 + a_{i,1} \cdot \Delta_x^i + a_{i,0}$$

5

$$s'(x_{i+1}) = 3 \cdot a_{i,3} \cdot (\Delta_x^i)^2 + 2 \cdot a_{i,2} \cdot \Delta_x^i + a_{i,1}$$

$$s''(x_{i+1}) = 6 \cdot a_{i,3} \cdot \Delta_x^i + 2 \cdot a_{i,2} \qquad (3.5)$$

Hier können die Ergebnisse für $a_{i,2}$, $a_{i,1}$ und $a_{i,0}$ aus den Gleichungen (3.3) eingesetzt werden:

$$s(x_{i+1}) = a_{i,3} \cdot (\Delta_x^i)^3 + \frac{1}{2} s''(x_i) \cdot (\Delta_x^i)^2 + s'(x_i) \cdot \Delta_x^i + y_i \qquad (3.6)$$

$$s'(x_{i+1}) = 3 \cdot a_{i,3} \cdot (\Delta_x^i)^2 + s''(x_i) \cdot \Delta_x^i + s'(x_i)$$

$$s''(x_{i+1}) = 6 \cdot a_{i,3} \cdot (\Delta_x^i) + s''(x_i) \qquad (3.7)$$

Mit $s(x_{i+1}) = y_{i+1}$ erhält man aus (3.6):

$$\Delta_y^i = a_{i,3} \cdot (\Delta_x^i)^3 + \frac{1}{2} s''(x_i) \cdot (\Delta_x^i)^2 + s'(x_i) \cdot (\Delta_x^i)$$

Auflösen nach $a_{i,3}$ ergibt nun

$$a_{i,3} = \frac{\Delta_y^i}{(\Delta_x^i)^3} - \frac{s''(x_i)}{2 \cdot \Delta_x^i} - \frac{s'(x_i)}{(\Delta_x^i)^2} \qquad (3.8)$$

Setzt man Gleichung (3.8) in die Gleichungen (3.7) ein, so erhält man Iterationsgleichungen für die ersten und zweiten Ableitungen $s'(x_i)$ und $s''(x_i)$:

$$s'(x_{i+1}) = 3 \cdot \Delta^i - \frac{1}{2} s''(x_i) \cdot \Delta_x^i - 2 \cdot s'(x_i)$$

$$s''(x_{i+1}) = 6 \frac{\Delta^i}{\Delta_x^i} - 2 \cdot s''(x_i) - 6 \frac{s'(x_i)}{\Delta_x^i} \qquad (3.9)$$

Analog gilt für $s''(x_{i+2})$:

$$s''(x_{i+2}) = 6 \frac{\Delta^{i+1}}{\Delta_x^{i+1}} - 2 \cdot s''(x_{i+1}) - 6 \frac{s'(x_{i+1})}{\Delta_x^{i+1}} \qquad (3.10)$$

Eliminiert man $s'(x_i)$ und $s'(x_{i+1})$ aus den Gleichungen (3.9) und (3.10), so erhält man eine Gleichung, in der nur noch die zweiten Ableitungen auftauchen:

$$s''(x_{i+2}) = 6 \frac{\Delta^{i+1} - \Delta^i}{\Delta_x^{i+1}} - 2 \cdot s''(x_{i+1}) \cdot (1 + d_i) - d_i \cdot s''(x_i) \qquad (3.11)$$

für $i \in M \backslash \{n-1, n\}$ und

$$d_i := \frac{\Delta_x^i}{\Delta_x^{i+1}}$$

Mit dem iterativen Ansatz

$$s''(x_i) = \alpha_i \cdot s''(x_{i+1}) + \beta_i \qquad (3.12)$$

($i \in M\backslash\{n\}$) und dem Anfangswert für einen natürlichen Spline

$$s''(x_n) = 0 \qquad (3.13)$$

erhält man für $i \in M\backslash\{n-1,n\}$ aus Gleichung (3.11):

$$6\,\frac{\Delta^{i+1} - \Delta^i}{\Delta_x^{i+1}} - d_i \cdot (\alpha_i \beta_{i+1} + \beta_i) - 2 \cdot (1 + d_i) \cdot \beta_{i+1} - s''(x_{i+2}) \cdot [1 + d_i \alpha_i \alpha_{i+1} + 2 \cdot \alpha_{i+1} \cdot (1 + d_i)] = 0 \qquad (3.14)$$

Gleichung (3.14) ist erfüllt, wenn die Rekursionsformeln

$$\alpha_{i+1} = -\,\frac{1}{\alpha_i d_i + 2 \cdot (1 + d_i)}$$

$$\beta_{i+1} = \frac{1}{\alpha_i d_i + 2 \cdot (1 + d_i)} \cdot [6\,\frac{\Delta^{i+1} - \Delta^i}{\Delta_x^{i+1}} - d_i \beta_i] \qquad (3.15)$$

für $i \in M\backslash\{n-1,n\}$ gelten. Da $|\alpha_1| \leq \frac{1}{2}$, folgt, daß stets auch $|\alpha_i| \leq \frac{1}{2}$ (vollständige Induktion). Aus Gleichung (3.12) erhält man für $i = 1$:

$$s''(x_1) = \alpha_1 \cdot s''(x_2) + \beta_1 \qquad (3.16)$$

Gleichung (3.16) ist nur für die Anfangswerte $\alpha_1 = 0$, $\beta_1 = s''(x_1)$ erfüllt, da laut Gleichung (3.12) $\alpha_1$, $\beta_1$ nicht von $s''(x_2)$ abhängen dürfen. Für den Fall eines natürlichen Splines erhält man also Anfangswerte

$$\alpha_1 = \beta_1 = 0. \qquad (3.17)$$

Die sukzessive Anwendung der Gleichungen (3.17) und (3.15) liefert die Koeffizienten $\alpha_i, \beta_i$ für $i \in M\backslash\{n\}$. Die sukzessive Anwendung der Gleichungen (3.13) und (3.12) liefert dann sämtliche zweiten Ableitungen $s''(x_i)$.
Nachfolgend werden die ersten Ableitungen $s'(x_i)$ berechnet. Aus Gleichung (3.9) folgt direkt, daß

$$s'(x_i) = \Delta^i - \frac{1}{3}\,\Delta_x^i[s''(x_i) + \frac{1}{2}s''(x_{i+1})] \qquad (3.18)$$

für $i \in M\backslash\{n\}$, sowie (Kombination beider Teilformeln)

$$s'(x_n) = \Delta^{n-1} + \frac{1}{3}\Delta_x^{n-1}[s''(x_n) + \frac{1}{2}s''(x_{n-1})]. \qquad (3.19)$$

Für einen natürlichen Spline erhält man also:

$$s'(x_n) = \Delta^{n-1} + \frac{1}{6}\Delta_x^{n-1} \cdot s''(x_{n-1}). \qquad (3.20)$$

Die Gleichungen (3.17), (3.15), (3.13), (3.12), (3.18), (3.20) und (3.3) stellen einen geschlossenen Algorithmus zur Berechung der Koeffizienten $a_{i,0}$, $a_{i,1}$, $a_{i,2}$ und $a_{i,3}$ des Splines in jedem Teilintervall $I_i$ ($i \in M\backslash\{n\}$) dar.

**Behandlung nicht-differenzierbarer Punkte**

Soll die Funktionskurve explizit nicht-differenzierbare Punkte enthalten, so läßt sich dies sehr einfach durch die Aufteilung der Menge der Datenpunkte $D = \{(x_i,y_i), i \in M\}$ in mehrere Untermengen erreichen: Sei $x_j$ mit $j \in M$ eine nicht-differenzierbare Stelle, so definiert man Untermengen $M_1 : = \{1,...,j\}$ und $M_2 := \{j,...,n\}$ der Menge M und wendet den zuvor beschriebenen Algorithmus separat auf die Mengen der Datenpunkte $D_1 := \{(x_i,y_i), i \in M_1\}$ und $D_2 := \{(x_i,y_i), i \in M_2\}$ an.

Sei nun $s_1$ der (natürliche) Spline zur Menge der Datenpunkte $D_1$ und $s_2$ der (natürliche) Spline zur Menge der Datenpunkte $D_2$. Dann gilt nach Gleichung (2.1) insbesondere, daß

$$s_1(x_j) = s_2(x_j) = y_j$$

Der durch die beiden Splines beschriebene Funktion ist also nach wie vor auf dem gesamten Intervall, insbesondere an der Stelle $x_j$ stetig. Im allgemeinen wird aber

$$s_1'(x_j) \neq s_2'(x_j)$$

sein, das heißt die Funktion ist an der Stelle $x_j$ nicht mehr differenzierbar. Der Kurvenverlauf weist also einen "Knick" auf.

Liegen mehrere nicht-differenzierbare Punkte vor, so kann analog eine weitere Aufteilung in Untermengen vorgenommen werden.

**Behandlung von Extremalpunkten**

Beim Auftreten von explizit vorgegebenen Extremalpunkten wird eine Aufteilung der Menge der Datenpunkte in Untermengen vorgenommen. Die Bedingung für einen Extremalpunkt an der Stelle $x_j$, $j \in M$ lautet

$$s'(x_j) = 0 \qquad\qquad (3.21)$$

Gleichung (3.21) stellt eine zusätzliche Forderung an den (natürlichen) Spline dar, er ist daher überbestimmt. Im folgenden wird beschrieben, in welcher Weise andere Anforderungen an den Spline zur Erfüllung von Gleichung (3.21) fallen gelassen werden und in welcher Weise der in Kapitel 3.3 beschriebene Algorithmus modifiziert wird.

Sei $U = \{(x_i,y_i), i \in \tilde{M}\}$, $\tilde{M} = \{j_1,...,j_2\}$ mit $j_1, j_2 \in N$ eine Untermenge von D. Ist $j_2 - j_1 +1 < 3$ (Teilintervall mit weniger als 3 Punkten), so wird der Algorithmus mit einem Fehler abgebrochen. Dann wird zunächst eine Neunumerierung der Indizes vorgenommen ($i \rightarrow i - j_1 + 1$), sodaß der Algorithmus auf eine Menge von Datenpunkten $(x_i,y_i)$, $i = 1,...,n$ wo $n = j_2 - j_1 + 1$ angewandt werden kann.

Es sind nun zwei sich nicht ausschließende Fälle zu unterscheiden: (1) $x_1$ ist ein Extremalpunkt und (2) $x_n$ ist ein Extremalpunkt.

**Fall (1):** Ist $x_1$ ein Extremalpunkt, so lautet Gleichung (2.2) sinngemäß

$$s'(x_1) = 0 \text{ und } s''(x_n) = 0 \qquad\qquad (3.22)$$

Der Spline ist mit Hilfe von Gleichung (3.22) eindeutig bestimmt. Allerdings erhält man jetzt keinen natürlichen Spline mehr, da die Bedingung $s''(x_1) = 0$ aufgegeben wurde. Daher müssen die in Gleichung (3.17) angegebenen Anfangswerte modifiziert werden:

Setzt man Gleichung (3.16) in Gleichung (3.18) für $i = 1$ ein, so erhält man:

$$s'(x_1) = \Delta^1 - \frac{1}{3}\Delta_x^1 \cdot \beta_1 - \frac{1}{2}s''(x_2) \cdot \Delta_x^1 \cdot [\alpha_1 + \frac{1}{2}]$$

Mit $s'(x_1) = 0$ ergeben sich die Anfangswerte $\alpha_1$, $\beta_1$ zu

$$\alpha_1 = -\frac{1}{2}$$

$$\beta_1 = 3\frac{\Delta^1}{\Delta^1_x} \tag{3.23}$$

Gleichung (3.16) wird also durch Gleichung (3.23) ersetzt.

**Fall (2):** Ist $x_n$ ein Extremalpunkt, so lautet Gleichung (2.2) sinngemäß

$$s''(x_1) = 0 \text{ und } s'(x_n) = 0 \tag{3.24}$$

Der Spline ist mit Hilfe von Gleichung (3.24) wiederum eindeutig bestimmt. Auch hier erhält man keinen natürlichen Spline. Daher muß der in Gleichung (3.13) angegebene Anfangswert modifiziert werden:

Löst man Gleichung (3.19) mit $s'(x_n) = 0$ nach $s''(x_n)$ auf und ersetzt $s''(x_{n-1})$ durch $s''(x_{n-1}) = \alpha_{n-1} \cdot (x_n) + \beta_{n-1}$, so ergibt sich

$$s''(x_n) = -3\frac{1}{1 + \frac{1}{2}\alpha_{n-1}} \cdot [\frac{\Delta^{n-1}}{\Delta^{n-1}_x} + \frac{1}{6}\beta_{n-1}]. \tag{3.25}$$

Der Fall $\alpha_{n-1} = -2$ (Pol im Nenner) ist dabei wegen $|\alpha_1| \leq \frac{1}{2}$ ausgeschlossen. Gleichung (3.13) wird also durch Gleichung (3.25) ersetzt

**Ablauf der Algorithmen**

Zunächst wird die zuvor bereits beschriebene Aufteilung der Menge der Datenpunkte in Untermengen vorgenommen, sofern nicht-differenzierbare beziehungsweise Extremalpunkte vorliegen. Dabei werden auch Kombinationen berücksichtigt, zum Beispiel kann eine Untermenge $U = \{(x_i, y_i), i \in \tilde{M}\}$, $\tilde{M} = \{j_1, ..., j_2\}$ mit $j_1, j_2 \in N$ mit dem nicht-differenzierbaren Punkt $x_{j_1}$ beginnen und mit dem Extremalpunkt $x_{j_2}$ enden, Analoges gilt für alle weiteren möglichen Kombinationen.

In einem zweiten Schritt werden dann die zuvor beschriebenen Algorithmen auf die Untermengen der Datenpunkte angewandt Dazu wird für jede Untermenge die erläuterte Neunumerierung der Indizes vorgenommen, sodaß die Algorithmen jeweils für Datenpunkte $(x_i, y_i)$ mit $i = 1, ..., n$ wo $n = j_2 - j_1 + 1$ durchgeführt werden.

Tritt während des Ablaufs ein Fehler auf, so wird der Algorithmus abgebrochen.

**Sonderfall: n=2**

In diesem Unterkapitel soll noch nachgewiesen werden, daß der beschriebene Algorithmus auch im Fall $n = 2$ (das heißt, wenn nur 2 Datenpunkte für die Interpolation zur Verfügung stehen) vernünftige Resultate liefert.

In diesem Fall liefert der Algorithmus (Gleichungen (3.18), (3.20)), daß $s'(x_1) = \Delta^1$ und somit $s'(x_2) = \Delta^1$. Für die Koeffizienten folgt: $a_{i,0} = y_1$, $a_{i,1} = \Delta^1$, $a_{i,2} = a_{i,3} = 0$ (Gleichung (3.3)). Der Spline lautet damit: $s(x) = \Delta^1 \cdot (x-x_1) + y_1$. Man erhält also erwartungsgemäß eine Gerade, die die beiden Datenpunkte $(x_1, y_1)$ und $(x_2, y_2)$ verbindet

**Berechnung von Schrittweiten**

Der Simulator kann zusätzlich zur Beschreibung des Bauteils durch mathematische Gleichungen noch Angaben darüber verlangen, mit welcher Genauigkeit (Schrittweite) diese Gleichungen in den entsprechenden Teilintervallen ausgeführt werden sollen. Dies ist zum Beispiel beim Analogsimulator SABER der Fall. Eine hohe Genauigkeit (geringe Schrittweite) kann erforderlich sein, wenn

- die Funktionskurve von dem linearen Verhalten einer Geraden abweicht,
- oder ein sich schnell ändernder Bereich der Kurve (große Steilheit) genauer betrachtet werden soll.

Im ersten Fall ist die Krümmung des Splines $s''(x)$ ein Maß für die Genauigkeit: Große Krümmung erfordert hohe Genauigkeit. Als Maßzahl kann das Maximum der Krümmung in einem vorgegebenen Intervall verwendet werden.

Dieses läßt sich leicht ermitteln, da die zweite Ableitung s"(x) ein lineares Polynom ist (es genügt, die Randwerte im jeweiligen Intervall $I_i$ zu betrachten).

Im zweiten Fall kann entweder auf die Steigung s'(x) oder besser auf die in Gleichung (2.6) beschriebene Bogenlänge b(s) des Splines zurückgegriffen werden. b(s) kann direkt als Maßzahl verwendet werden, das Maximum der Steigung muß aus den Randwerten und dem möglicherweise vorhandenen relativen Extrema (Bestimmungsgleichung s'($x_E$)=0) bestimmt werden.

## Anwendungsbeispiel

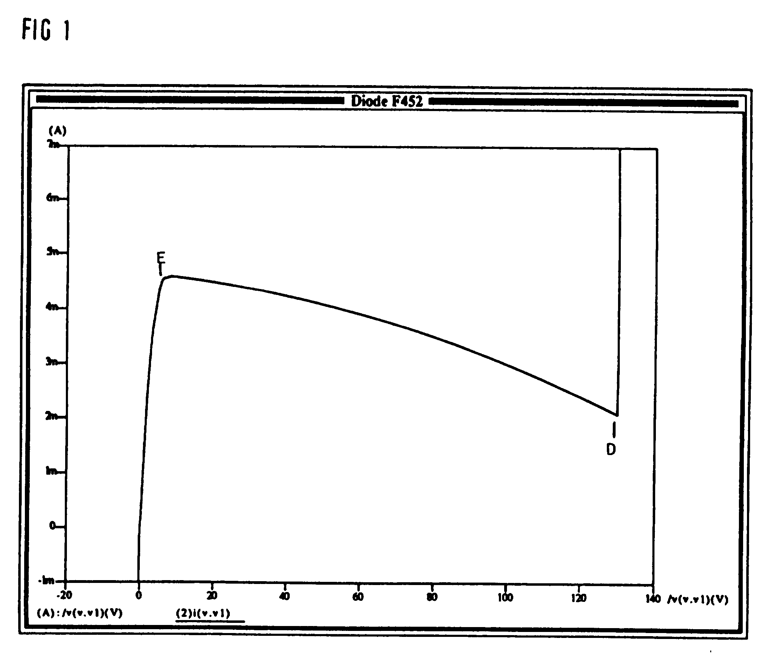

In diesem Unterkapitel soll die Anwendung unseres Verfahrens an einem konkreten Beispiel erprobt werden. Dafür wurde eine Strombegrenzerdiode vom Typ F452 ausgewählt. Die Kennlinie der Diode enthält sowohl einen Extremalpunkt als auch einen nicht-differenzierbaren Punkt. Vom Vertreiber war ein Datenblatt verfügbar, aus dem Datenpunkte der Kennlinie entnommen werden konnten. Tabelle 1 zeigt eine Liste der Datenpunkte, wie sie dem Verfahren als Eingabe zur Verfügung gestellt wurden. Es wurde mit einem Analogsimulator simuliert (DC Transfer Analyse). Figur 1 zeigt die Kennlinie der Diode, wie sie sich als Ergebnis der Simulation ergibt.

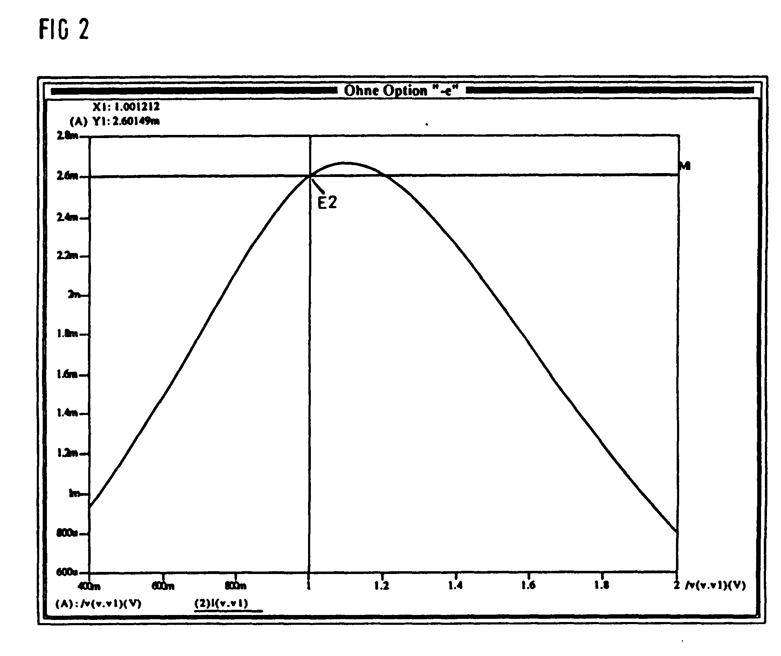

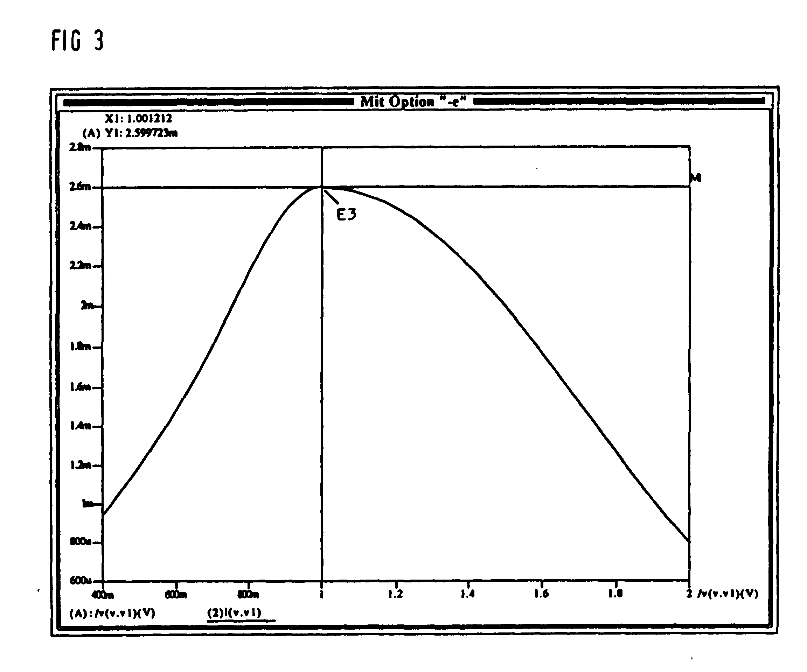

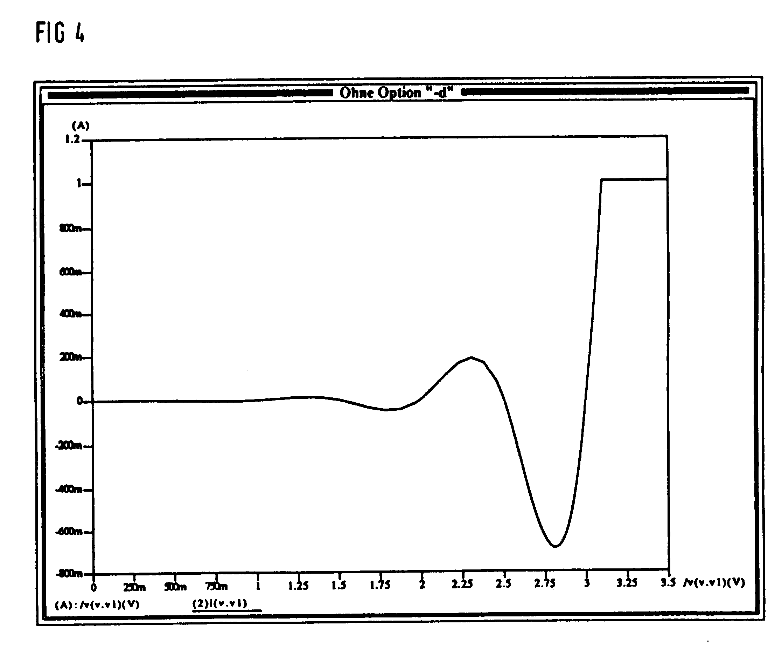

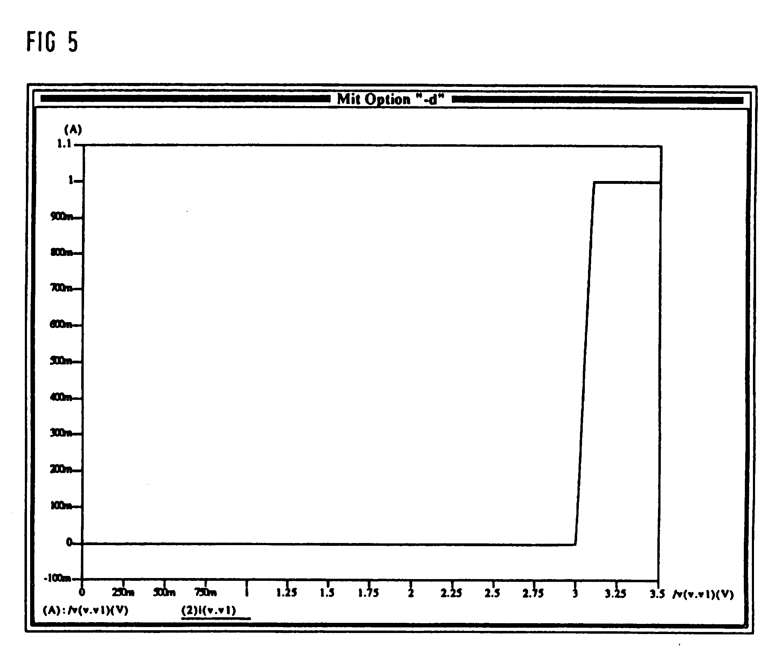

Zur Verdeutlichung des Einflusses von explizit vorgegebenen nicht-differenzierbaren beziehungsweise Extremalpunkten wurde das Verfahren mit und ohne deren explizite Vorgabe durchgeführt. Tabelle 2 zeigt zunächst wieder eine Liste von Datenpunkten, wie sie als Eingabe dienten. Das Maximum liegt bei einer Spannung von 1 Volt. Figur 2 zeigt die Simulation ohne vorgegebenen Maximalpunkt. Man erkennt deutlich die Verschiebung des Maximums um ca. 0.1 Volt hin zu höheren Werten. Das Ergebnis der Modellierung mit vorgegebenem Extremalpunkt, ist in Figur 3 zu sehen: Die Funktionskurve nimmt ihr Maximum jetzt genau bei dem definierten Wert von 1 Volt an. Die Auswirkung von nicht-differenzierbaren Punkten ist in den Figuren 4 und 5 dargestellt: In Figur 4 erkennt man das unerwünschte "Schwingen" des Splines, wenn die "Durchbruchsspannung" bei 3 Volt nicht als nicht-differenzierbarer Punkt kenntlich gemacht wird. Das Problem wird, wie man in Figur 5 sieht, durch die explizite Vorgabe solcher Punkte vollständig behoben.

Die den Funktionskurven, welche in den Figuren dargestellt sind, zugrundeliegenden Wertpaare befinden sich in den gleich bezeichneten Tabellen.

In Figur 1 ist das Ergebnis der Simulation einer Diode F452 mit dem erfindungsgemäßen Verfahren dargestellt. (Strom-Spannungs-Charakteristik). Dieser Simulation liegen die Wertepaare aus Tabelle 1 zugrunde. Sie werden für das erfindungsgemäße Verfahren vereinfacht dargestellt. Zunächst wird mit "scale 1e-3" die Darstellung der Wertepaare in Exponentialform vereinbart. Ein Punkt wird mit der Bezeichnung point gekennzeichnet. Es folgt das Wertepaar horizontal in den nächsten beiden Spalten. Anschließend ist eine Kennzeichnung angegeben, die dem erfindungsgemäßen Verfahren mitteilt, ob bei der Berechnung dieses Punktes besondere Charakteristika zu beachten sind. -s bedeutet einen normalen Datenpunkt, -d bedeutet einen nicht differenzierbaren Datenpunkt, -e bedeutet einen Extremalwert.

Deutlich kann man am Ergebnis der Simulation erkennen, daß der Extremwert E bei einer Spannung von 8 Volt, sowie der nicht differenzierbare Punkt D (Knick) bei der Spannung 130 Volt vom erfindungsgemäßen Verfahren korrekt wiedergegeben werden.

In Figur 2 ist das Simulationsergebnis eines Bauteils dargestellt, das am Punkt 1 und 2,6 ein Maximum M nicht überschreiten darf. Dem simulierten Ergebnis liegen die in der Tabelle 2 dargestellten Wertepaare zugrunde. Wie man deutlich erkennen kann, ist der Punkt E2 , der in den Wertepaaren als Maximum vorgesehen ist, zwar im Simulationsergebnis Bestandteil der Funktionskurve, aber er ist nicht das Maximum. Bei der hier durchgeführten Simulation wurde in der Definition der Wertepaare das im erfindungsgemäßen Verfahren vorgesehene Kriterium für Extremalwerte "-e" nicht eingesetzt. Dies äußert sich in einer Verschiebung des Maximums im dargestellten Kurvenverlauf.

Figur 3 zeigt den Kurvenverlauf wie er sich nach der Simulation mit dem erfindungsgemäßen Verfahren ergibt, dem dieselbe Eingangswertepaarschar zugrundeliegt, wie bei Figur 2, mit Ausnahme, daß der Punkt 1 und 2,6 in Tabelle 3 als Extremwert mit "-e" gekennzeichnet ist. Hier kann man deutlich erkennen, daß sich der Extremalwert E3 gegenüber der in Figur 2 dargestellten Version verschoben hat und sich nun annähernd an der richtigen Stelle befindet.

In Figur 4 ist ein Bauteil mit dem erfindungsgemäßen Verfahren simuliert, dessen charakteristische Eigenschaften in Wertepaartabelle 4 dargestellt werden. Kennzeichnend für dieses Bauteil ist, daß seine Funktionskurve bei einer Spannung von 3 Volt einen nicht differenzierbaren Punkt (Knick) aufweist. Für die Simulation wurde dieser Punkt nicht durch eine Option "-d" in der Tabelle 4 explizit kenntlich gemacht. Das Ergebnis der Simulation zeigt deutlich, daß das Bauteil während der Simulation zum Schwingen neigt und daß der Kurvenverlauf, der das Bauteil charakterisiert, durch die Simulation nicht korrekt dargestellt wird.

Figur 5 zeigt das Ergebnis einer Simulation mit dem erfindungsgemäßen Verfahren, welcher die Wertepaare aus der Tabelle 5 zugrundeliegen. Tabelle 5 unterscheidet sich durch Tabelle 4, die in Figur 4 simuliert wurde, nur dadurch, daß der Punkt bei 3 Volt nun mit der Option "- d" als nicht differenzierbar gekennzeichnet wurde. Deutlich kann man erkennen, daß die Simulation mit dem erfindungsgemäßen Verfahren nun zu einem korrekten Ergebnis führt, welches charakteristische Eigenschaften des Bauteils beschreibt. Das heißt, der Knick bei einer Spannung von 3 Volt wird korrekt wiedergegeben .

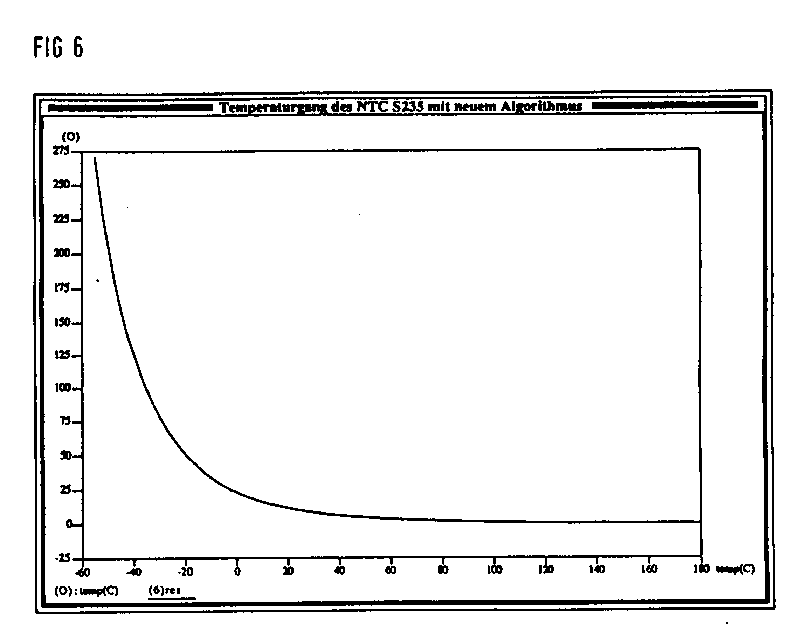

Figur 6 zeigt das Ergebnis einer Simulation mit dem erfindungsgemäßen Verfahren, welcher die Wertepaare aus der Tabelle 6 zugrundeliegen. Hier soll insbesondere das Verhalten des erfindungsgemäßen Verfahrens gezeigt werden, wenn eine große Menge von Wertepaaren eingegeben wird. Hier wird die Temperaturkuve des Heißleiters S235 (Siemens-Matsushita) simuliert. Deutlich kann man erkennen, daß die Simulation mit dem erfindungsgemäßen Verfahren auch bei einer großen Zahl von eingegebenen Wertepaaren zu einem korrekten Ergebnis führt.

Tabelle 1:

| scale 1e-3 | | | |
|---|---|---|---|
| point | -0.9 | -881. | -s |
| point | -0.6 | -302. | -s |
| point | -0.5 | -149. | -s |
| point | -0.4 | -46. | -s |
| point | -0.3 | -8.18 | -s |
| point | -0.2 | -1.1 | -s |
| point | -0.1 | -0.138 | -s |
| point | 0. | 0. | -d |
| point | 0.5 | 0.6 | -s |
| point | 0.7 | 0.9 | -s |
| point | 1. | 1.3 | -s |
| point | 1.5 | 2. | -s |
| point | 2. | 2.5 | -s |
| point | 3. | 3.3 | -s |
| point | 4. | 3.8 | -s |
| point | 5. | 4.2 | -s |
| point | 7. | 4.38 | -s |
| point | 8. | 4.4 | -e |
| point | 8.1 | 4.4 | -s |
| point | 10. | 4.39 | -s |
| point | 130. | 2.5 | -d |
| point | 131. | 1000. | -s |

Tabelle 2

| scale 1e-3 | | | |
|---|---|---|---|
| point | 0. | 0. | -s |
| point | 0.5 | 1.2 | -s |
| point | 0.7 | 1.8 | -s |
| point | 1. | 2.6 | -s |
| point | 1.5 | 2.0 | -s |
| point | 2. | 0.8 | -s |
| point | 3. | 0.0 | -s |

Tabelle 3

| scale 1e-3 | | | |
|---|---|---|---|
| point | 0. | 0. | -s |
| point | 0.5 | 1.2 | -s |
| point | 0.7 | 1.8 | -s |
| point | 1. | 2.6 | -e |
| point | 1.5 | 2.0 | -s |

Tabelle 3   (fortgesetzt)

| scale 1e-3 | | | |
|---|---|---|---|
| point | 2. | 0.8 | -s |
| point | 3. | 0.0 | -s |

Tabelle 4

| scale 1e-3 | | | |
|---|---|---|---|
| point | 0. | 0. | -s |
| point | 0.5 | 0.1 | -s |
| point | 1.0 | 0.2 | -s |
| point | 1.5 | 0.4 | -s |
| point | 2. | 0.6 | -s |
| point | 2.5 | 0.9 | -s |
| point | 3. | 1.2 | -s |
| point | 3.1 | 1000.0 | -s |

Tabelle 5

| scale 1e-3 | | | |
|---|---|---|---|
| point | 0. | 0. | -s |
| point | 0.5 | 0.1 | -s |
| point | 1.0 | 0.2 | -s |
| point | 1.5 | 0.4 | -s |
| point | 2. | 0.6 | -s |
| point | 2.5 | 0.9 | -s |
| point | 3. | 1.2 | -d |
| point | 3.1 | 1000.0 | -s |

## Tabelle 6

scale 1e1

| point | -55 | 27.119 | -s |
|---|---|---|---|
| point | -50 | 20.748 | -s |
| point | -45 | 16.035 | -s |
| point | -40 | 12.521 | -s |
| point | -35 | 9.8633 | -s |
| point | -30 | 7.8415 | -s |
| point | -25 | 6.2836 | -s |
| point | -20 | 5.0768 | -s |
| point | -15 | 4:1312 | -s |
| point | -10 | 3.3866 | -s |
| point | -5 | 2.7944 | -s |
| point | 0 | 2.3211 | -s |
| point | 5 | 1.9315 | -s |
| point | 10 | 1.6303 | -s |
| point | 15 | 1.3779 | -s |
| point | 20 | 1.1709 | -s |
| point | 25 | 1 | -s |
| point | 30 | 0.85816 | -s |
| point | 35 | 0.73986 | -s |
| point | 40 | 0.64074 | -s |
| point | 45 | 0.55721 | -s |
| point | 50 | 0.48657 | -s |
| point | 55 | 0.42652 | -s |
| point | 60 | 0.37530 | -s |
| point | 65 | 0.33141 | -s |
| point | 70 | 0.29364 | -s |
| point | 75 | 0.26105 | -s |
| point | 80 | 0.23280 | -s |
| point | 85 | 0.20826 | -s |
| point | 90 | 0.18683 | -s |
| point | 95 | 0.16809 | -s |
| point | 100 | 0.15164 | -s |
| point | 105 | 0.13715 | -s |
| point | 110 | 0.12436 | -s |
| point | 115 | 0.11304 | -s |
| point | 120 | 0.10299 | -s |
| point | 125 | 0.094040 | -s |
| point | 130 | 0.086055 | -s |
| point | 135 | 0.078918 | -s |
| point | 140 | 0.072516 | -s |
| point | 145 | 0.066766 | -s |
| point | 150 | 0.061586 | -s |
| point | 155 | 0.056912 | -s |
| point | 160 | 0.052685 | -s |

| point | 165 | 0.048857 | -s |
|-------|-----|----------|-----|
| point | 170 | 0.045380 | -s |
| point | 175 | 0.042221 | -s |
| point | 180 | 0.039341 | -s |

## Literaturverzeichnis

[1] H. Spiro: Simulation integrierter Schaltungen durch universelle Rechnerprogramme, R. Oldenbourg Verlag GmbH. München, 1985.

[2] H. Wiedemann (Racal-Redac-Design-System-GmbH): Übergeordnete Aspekte beim ASIC-Entwurf, in: Tagungsband SMT/ASIC/Hybrid '91, 5. Internationale Fachmesse und Kongress, VDE-Verlag, Berlin, 1991.

[3] H. Stump (Logic Modeling Systems Incorporated): Trends in Technology and EDA for the 1990s, in: Conference Record Electro/90, Ventura USA, 1990.

[4] B. Tuck: What Do Digital Designers Need to Master the Art of Analog Design. in: Comput. Des. 30 11, 1991.

[5] US-A-5 047 971

[6] IEEE COMPUTER GRAPHICS AND APPLICATIONS, vol. 10, Nr. 1, January 1990, LOS ALAMITOS CA, US; pages 10-17; FLETCHER et al.: "Automatic tension adjustment for interpolatory splines"

## Patentansprüche

1. Verfahren zur Simulation wenigstens eines Bauelementes, dessen Kennlinie durch eine Menge von Wertepaaren beschrieben wird, mit Hilfe eines Simulators auf einem Rechner, bei dem

   a) in einem ersten Schritt für eine Spline-Interpolation eine kubische Splinefunktion der Form:

   $$s(x) = a_{i,3} \cdot (x\text{-}x_i)^3 + a_{i,2} \cdot (x\text{-}x_i)^2 + a_{i,1} \cdot (x\text{-}x_i) + a_{i,0}$$

   verwendet wird mit Wertepaaren

   $$(x_i, y_i), \; i = 1, \ldots, n$$

   mit $n \in N$
   die dem Betrag von $x_i$ nach in aufsteigender Reihenfolge sortiert sind und die Intervallgrenzen der Teilintervalle für die Spline-Interpolation bilden,

   b) die Koeffizienten

   $$a_{i,3}, \; a_{i,2}, \; a_{i,1}, \; a_{i,0}$$

   für jedes Teilintervall zu:

   $$a_{i,0} = y_i$$

$$a_{i,1} = s'(x_i)$$

$$a_{i,2} = \frac{1}{2} \cdot s''(x_i)$$

$$a_{i,3} = \frac{s''(x_{i+1}) - s''(x_i)}{6 \cdot (x_{i+1} - x_i)}$$

bestimmt werden mit den Rekursionsformeln

$$s'(x_i) = \Delta^i - \frac{1}{3}\Delta_x^i[s''(x_i) + \frac{1}{2}s''(x_{i+1})]$$

$$s'(x_n) = \Delta^{n-1} + \frac{1}{6}\Delta_x^{n-1} \cdot s''(x_{n-1})$$

$$\Delta_x^i := x_{i+1} - x_i$$

$$\Delta_y^i = y_{i+1} - y_i$$

$$\Delta^i := \frac{\Delta_y^i}{\Delta_x^i}$$

$$d_i := \frac{\Delta_x^i}{\Delta_x^{i+1}}$$

und unter Verwendung von

$$s''(x_i) = \alpha_i * s''(x_{i+1}) + \beta_i$$

$$\alpha_{i+1} = -\frac{1}{\alpha_i d_i + 2 \cdot (1 + d_i)}$$

$$\beta_{i+1} = \frac{1}{\alpha_i d_i + 2 \cdot (1 + d_i)} \cdot [6\frac{\Delta^{i+1} - \Delta^i}{\Delta_x^{i+1}} - d_i\beta_i]$$

$$\alpha_1 = \beta_1 = 0.$$

sowie der Randbedingungen für natürliche Splines

$$s''(x_1) = 0 \text{ und } s''(x_n) = 0$$

für alle Wertepaare eine Funktion s(x) gefunden wird, welche jeweils dem einen Wen eines jeweiligen Wertepaares den anderen Wert des Wertepaares zuordnet,
wobei Index " ' " 1. Ableitung bedeutet,

sowie Index " " " 2. Ableitung bedeutet,

c) in einem weiteren Schritt die gefundene Funktion im Simulator verwendet wird, um für das Bauelement beliebige Wertepaare zu ermitteln.

**2.** Verfahren nach Anspruch 1, bei dem

a) ein nicht differenzierbarer Punkt (D) im Verlauf der Funktion dadurch erzeugt wird, daß die Menge der Wertepaare in zwei Teilmengen unterteilt wird in denen der Punkt enthalten ist,

b) die Spline-Interpolation für jede Teilmenge durchgeführt wird, wobei der Punkt einmal als obere Intervallgrenze und das andere Mal als untere Intervallgrenze bezogen auf die 2 Teilmengen für die Spline-Interpolation verwendet wird.

**3.** Verfahren nach einem der Ansprüche 1 oder 2, bei dem der Funktion Extremalpunkte (E) vorgegeben werden, indem die Koeffizienten a mit denselben Rekursionsformeln auf folgende Weise bestimmt werden:

a) für $x_1$ als Extremalpunkt unter Verwendung von:

$$\alpha_1 = -\frac{1}{2}$$

$$\beta_1 = 3\frac{\Delta_1^1}{\Delta_x^1}$$

sowie den Extremwertbedingungen

$$s'(x_1) = 0 \text{ und } s''(x_n) = 0$$

b) für $x_n$ als Extremalpunkt unter Verwendung von:,

$$s''(x_n) = -3\frac{1}{1+\frac{1}{2}\alpha_{n-1}} \cdot [\frac{\Delta^{n-1}}{\Delta_x^{n-1}} + \frac{1}{6}\beta_{n-1}].$$

sowie den Extremwertbedingungen:

$$s''(x_1) = 0 \text{ und } s'(x_n) = 0$$

**Claims**

**1.** Method of simulating at least one component, whose characteristic is described by a set of pairs of values, by means of a simulator on a computer, in which

a) in a first step for the spline interpolation a cubic spline function of the form:

$$s(x) = a_{i,3}\cdot(x-x_i)^3 + a_{i,2}\cdot(x-x_i)^2 + a_{i,1}\cdot(x-x_i) + a_{i,0}$$

is used, with pairs of values

$$(x_i, y_i), i = 1, \ldots, n$$

where $n \in N$
which are sorted in ascending sequence according to the magnitude of $x_i$ and form the interval limits of the partial intervals for the spline interpolation,

b) the coefficients

$$a_{i,3}, \, a_{i,2}, \, a_{i,1}, \, a_{i,0}$$

for each partial interval are determined as:

$$a_{i,0} = y_i$$

$$a_{i,1} = s'(x_i)$$

$$a_{i,2} = \tfrac{1}{2} \cdot s''(x_i)$$

$$a_{i,3} = \frac{s''(x_{i+1}) - s''(x_i)}{6 \cdot (x_{i+1} - x_i)}$$

using the recursion formulae

$$s'(x_i) = \Delta^i - \frac{1}{3} \Delta_x^i [s''(x_i) + \frac{1}{2} s''(x_{i+1})]$$

$$s'(x_n) = \Delta^{n-1} + \frac{1}{6} \Delta_x^{n-1} \cdot s''(x_{n-1})$$

$$\Delta_x^i := x_{i+1} - x_i$$

$$\Delta_y^i = y_{i+1} - y_i$$

$$\Delta^i := \frac{\Delta_y^i}{\Delta_x^i}$$

$$d_i := \frac{\Delta_x^i}{\Delta_x^{i+1}}$$

and with the use of

$$s''(x_i) = \alpha_i * s''(x_{i+1}) + \beta_i$$

$$\alpha_{i+1} = -\frac{1}{\alpha_i d_i + 2 \cdot (1 + d_i)}$$

$$\beta_{i+1} = \frac{1}{\alpha_i d_i + 2 \cdot (1 + d_i)} \cdot [6 \frac{\Delta^{i+1} - \Delta^i}{\Delta_x^{i+1}} - d_i \beta_i]$$

$$\alpha_1 = \beta_1 = 0.$$

as well as the boundary conditions for natural splines

$$s''(x_1) = 0 \text{ and } s''(x_n) = 0$$

for all pairs of values a function $s(x)$ is found which allocates in each instance to the one value of a respective pair of values the other value of the pair of values,
Index " ' " signifying 1st derivative
and Index " " " signifying 2nd derivative

c) in a further step, the function found is used in the simulator in order to determine arbitrary pairs of values for the component.

2. Method according to Claim 1, in which

a) a non-differentiable point (D) in the progression of the function is generated in that the set of pairs of values is subdivided into two subsets, in which the point is included,

b) the spline interpolation is carried out for each subset, the point being used on one occasion as upper interval bound and on the other occasion as lower interval bound related to the 2 subsets for the spline interpolation.

3. Method according to one of Claims 1 or 2, in which extreme points (E) are prescribed for the function, in that the coefficients a are determined using the same recursion formulae in the following manner:

a) for $x_1$ as extreme point with the use of:

$$\alpha_1 = -\frac{1}{2}$$

$$\beta_1 = 3 \frac{\Delta^1}{\Delta_x^1}$$

as well as the extreme value conditions

$$s'(x_1) = 0 \text{ and } s''(x_n) = 0$$

b) for $x_n$ as extreme point with the use of:

$$s''(x_n) = -3 \frac{1}{1 + \frac{1}{2}\alpha_{n-1}} \cdot [\frac{\Delta^{n-1}}{\Delta_x^{n-1}} + \frac{1}{6}\beta_{n-1}].$$

as well as the extreme value conditions:

$$s''(x_1) = 0 \text{ and } s'(x_n) = 0$$

**Revendications**

1. Procédé de simulation d'au moins un composant dont la caractéristique est décrite par un ensemble de couples de valeurs, au moyen d'un simulateur assisté par ordinateur, dans lequel :

   a) on utilise dans une première phase, pour une interpolation spline, une fonction spline cubique notée sous la forme :

   $$s(x) = a_{i,3} \cdot (x-x_i)^3 + a_{i,2} \cdot (x-x_i)^2 + a_{i,1} \cdot (x-x_i) + a_{i,0}$$

   ayant les couples de valeurs

   $$(x_i, y_i), \, i = 1, ..., n$$

   avec $n \in N$
   qui sont classées en ordre ascendant selon la valeur de $x_i$ et définissent les limites d'intervalle des intervalles partiels pour l'interpolation spline ;
   b) on calcule les coefficients

   $$a_{i,3}, \, a_{i,2}, \, a_{i,1}, \, a_{i,0}$$

   pour chaque intervalle partiel, pour :

   $$a_{i,0} = y_i$$

   $$a_{i,1} = s'(x_i)$$

   $$a_{i,2} = \frac{1}{2} \cdot s''(x_i)$$

   $$a_{i,3} = \frac{s''(x_{i+1}) - s''(x_i)}{6 \cdot (x_{i+1} - x_i)}$$

   à l'aide des formules de récurrence

   $$s'(x_i) = \Delta^i - \frac{1}{3}\Delta_x^i [s''(x_i) + \frac{1}{2}s''(x_{i+1})]$$

   $$s'(x_n) = \Delta^{n-1} + \frac{1}{6}\Delta_x^{n-1} \cdot s''(x_{n-1})$$

   $$\Delta_x^i := x_{i+1} - x_i$$

   $$\Delta_y^i = y_{i+1} - y_i$$

   $$\Delta^i := \frac{\Delta_y^i}{\Delta_x^i}$$

$$d_i := \frac{\Delta_x^i}{\Delta_x^{i+1}}$$

et en utilisant

$$s''(x_i) = \alpha_i * s''(x_{i+1}) + \beta_i$$

$$\alpha_{i+1} = -\frac{1}{\alpha_i d_i + 2 \cdot (1 + d_i)}$$

$$\beta_{i+1} = \frac{1}{\alpha_i d_i + 2 \cdot (1 + d_i)} \cdot [6\frac{\Delta^{i+1} - \Delta^i}{\Delta_x^{i+1}} - d_i \beta_i]$$

$$\alpha_i = \beta_i = 0.$$

et les conditions additionnelles applicables aux splines naturels

$$s''(x_i) = 0 \text{ et } s''(x_n) = 0$$

on trouve pour tous les couples de valeurs une fonction s(x) qui associe à chaque fois à l'une des valeurs d'un couple de valeurs l'autre valeur du couple de valeurs,

l'indice " ' " signifiant dérivée première, et

l'indice " " " signifiant dérivée seconde ;

c) on utilise dans une autre phase la fonction trouvée dans le simulateur pour déterminer des couples de valeurs quelconques pour le composant.

2. Procédé selon la revendication 1, dans lequel

a) on génère dans le tracé de la fonction un point non dérivable (D) en divisant l'ensemble des couples de valeurs en deux sous-ensembles, dans lesquels le point est inclus.

b) on effectue l'interpolation spline pour chaque sous-ensemble, le point étant utilisé une fois comme limite supérieure de l'intervalle et l'autre fois comme limite inférieure de l'intervalle par rapport aux deux sous-ensembles de l'interpolation spline.

3. Procédé selon l'une des revendications 1 ou 2, dans lequel on impose à la fonction des points extrémaux (E) en calculant les coefficients a à l'aide des mêmes formules récurrentes de la manière suivante :

a) on utilise pour $x_1$ comme point extrémal :

$$\alpha_1 = -\frac{1}{2}$$

$$\beta_1 = 3\frac{\Delta^1}{\Delta_x^1}$$

ainsi que les conditions des valeurs extrêmes :

$$s'(x_1) = 0 \quad \text{et} \quad s''(x_n) = 0$$

b) on utilise pour $x_n$ comme point extrémal :

$$s''(x_n) = -3 \, \frac{1}{1 + \frac{1}{2}\alpha_{n-1}} \cdot [\frac{\Delta^{n-1}}{\Delta_x^{n-1}} + \frac{1}{6}\beta_{n-1}].$$

ainsi que les condition des valeurs extrêmes :

$$s'(x_1) = 0 \quad \text{et} \quad s''(x_n) = 0.$$

FIG 1

EP 0 655 152 B1

# FIG 2

EP 0 655 152 B1

# FIG 3

Mit Option "-e"

X1: 1.001212
(A) Y1: 2.599723m

(A) : /v(v.v1)(V)     (2)i(v.v1)

EP 0 655 152 B1

FIG 4

# FIG 5

Mit Option "-d"

(A): N(v.v1)(V)    (2)I(v.v1)

EP 0 655 152 B1

FIG 6

EP 0 655 152 B1

Temperaturgang des NTC S235 mit neuem Algorithmus